# EUROPÄISCHE PATENTSCHRIFT

(11) **EP 0 779 647 B1**
(45) Veröffentlichungstag und Bekanntmachung des Hinweises auf die Patenterteilung: **17.06.1998**
(21) Anmeldenummer: 96119964.3
(22) Anmeldetag: 12.12.1996
(51) Int. Cl.: H01L 21/00, B28D 5/02, B23D 59/02, B23D 59/00

(54) **Verfahren und Vorrichtung zur Bearbeitung von Halbleitermaterial**
Method and apparatus for treatment of semiconductor material
Méthode et appareil pour le traitement de matériaux semi-conducteurs

(30) Priorität: 15.12.1995 DE 19646988
(43) Veröffentlichungstag der Anmeldung: 18.06.1997
(73) Patentinhaber: Wacker Siltronic Gesellschaft für Halbleitermaterialien Aktiengesellschaft, 84489 Burghausen (DE)
(72) Erfinder: Lundt, Holger, Dr., 84489 Burghausen (DE); Kobler, Karl, 5230 Mattighofen (AT); Malcok, Hanifi, 84489 Burghausen (DE)
(74) Vertreter: Rimböck, Karl-Heinz, Dr.

(56) Entgegenhaltungen:
- EP-A- 0 476 952
- US-A- 4 498 345
- PATENT ABSTRACTS OF JAPAN vol. 95, no. 010 & JP 07 283183 A (KOKUSAI DENKI L TEC:KK;OTHERS: 01), 27.Oktober 1995,
- PATENT ABSTRACTS OF JAPAN vol. 014, no. 564 (E-1013), 14.Dezember 1990 & JP 02 246115 A (HITACHI LTD), 1.Oktober 1990,
- PATENT ABSTRACTS OF JAPAN vol. 014, no. 099 (E-0893), 22.Februar 1990 & JP 01 303724 A (HITACHI LTD), 7.Dezember 1989,

## Beschreibung

Gegenstand der Erfindung ist ein Verfahren zur Bearbeitung von Halbleitermaterial mit einem Schleifwerkzeug und unter Zuführung eines Reinigungsmittels zur Arbeitsfläche des Schleifwerkzeugs, wobei das Reinigungsmittel mit Schallwellen einer bestimmten Frequenz und einer bestimmten Intensität beaufschlagt wird. Gegenstand der Erfindung ist auch eine Vorrichtung zur Durchführung des Verfahrens.

Die Bearbeitung von Halbleitermaterial mit Schleifwerkzeugen erfordert häufig äußerste Präzision. Dies gilt besonders für die Herstellung von Halbleiterscheiben aus einem stabförmigen Kristall mit Hilfe von Trennschleifmaschinen, sogenannten Innenlochsägen. Bei diesem Vorgang kommt es darauf an, daß die erzeugten Halbleiterscheiben möglichst ebene und parallele Seitenflächen aufweisen. Geometrische Fehler äußern sich insbesondere in einer Durchbiegung der Scheiben, die im Fachjargon als warp bezeichnet wird. Es werden ständig Anstrengungen unternommen, um den warp der Halbleiterscheiben bei ihrer Gewinnung von einem Kristallstab möglichst gering zu halten.

Aus der US-5,313,741 ist ein Trennschleif-Verfahren bekannt, bei dem die Schneidkraft, die das Sägeblatt auf das Werkstück ausübt, laufend in Schneidrichtung und in zwei dazu orthogonalen Richtungen gemessen wird. Begleitend zu diesem Vorgang wird eine Reinigungsflüssigkeit aus einer Düse gegen die Schneidkante der Innenlochsäge gespritzt und der Flüssigkeitsstrahl aus einer externen Quelle mit Ultraschall beaufschlagt. Überschreitet die gemessene Schneidkraft einen bestimmten Grenzwert, so werden gleichzeitig die Vorschubgeschwindigkeit verringert und die Rotationsgeschwindigkeit des Sägeblatts erhöht. Obwohl dieses Verfahren niedrigere warp-Werte bei den erzeugten Halbleiterscheiben erwarten läßt, so muß durch die Verringerung der Vorschubgeschwindigkeit auch ein wirtschaftlicher Nachteil in Kauf genommen werden, weil die Ausbringung an Halbleiterscheiben pro Maschine und Zeiteinheit reduziert ist.

Die Aufgabe der Erfindung bestand darin, den genannten Nachteil zu vermeiden.

Gegenstand der Erfindung ist ein Verfahren der genannten Gattung, das dadurch gekennzeichnet ist, daß das Reinigungsmittel in Form von mindestens zwei Reinigungsmittel-Strahlen gegen die Arbeitsfläche des Schleifwerkzeugs gelenkt wird, die sich darin unterscheiden, daß sie mit Schallwellen unterschiedlicher Frequenz beaufschlagt sind.

Wird die Erfindung zur Herstellung von Halbleiterscheiben durch Trennschleifen eines Kristallstabs mittels einer Innenlochsäge verwendet, so läßt sich nicht nur feststellen, daß die erzeugten Halbleiterscheiben geringere warp-Werte aufweisen, sondern auch, daß eine Erhöhung der Vorschubgeschwindigkeit des Schleifwerkzeugs und deshalb eine Steigerung der Ausbringung von Halbleiterscheiben pro Maschine und Zeiteinheit möglich ist. Der Grund dafür ist auf die stark verbesserte Wirkung des Reinigungsmittels zurückzuführen, die verhindert, daß sich der Schneidraum hinter dem abrasiven Schleifkorn (z.B. Diamantkorn) zusetzt.

Die Erfindung eignet sich durch die zu verzeichnende Ausbringungs-Steigerung grundsätzlich für alle Arten der schleifenden Behandlung von Halbleitermaterial und ist nicht auf die Behandlung von Halbleiterscheiben beschränkt. Bevorzugte Einsatzgebiete für die Erfindung sind neben dem Zerteilen eines Kristallstabs zu Halbleiterscheiben, das Verrunden der Kanten von Halbleiterscheiben in Dickenrichtung und entlang ihrer Umfangslinien, das Rundschleifen von Kristallstäben und das Schleifen ebener Flächen mit Topf-Schleifscheiben, wie beispielsweise die schleifende Behandlung der Seitenflächen von Halbleiterscheiben oder der Stabstirnfläche eines Kristallstabs.

Gemäß einer Ausführungsform der Erfindung wird während des Schleifvorgangs ein Reinigungsmittel aus mindestens zwei Düsen gegen die Arbeitsfläche des Schleifwerkzeugs, beispielsweise gegen die Schneidkante einer Innenlochsäge, gelenkt. Dabei wird das Reinigungsmittel noch in den Düsen mit Schallwellen unterschiedlicher Frequenz beaufschlagt.

Diesem Verfahren liegt die Erkenntnis zu Grunde, daß zwischen der Reinigungswirkung des Reinigungsmittels, der Frequenz der Schallwellen und der Größe der beim Schleifen erzeugten Partikel des zerspanten Halbleitermaterials ein Zusammenhang besteht. Bei Einwirkung von Schallwellen mit relativ hohen Frequenzen werden bevorzugt relativ kleine Partikel und bei Einwirkung von Schallwellen mit relativ niedrigen Frequenzen bevorzugt relativ große Partikel entfernt. Größe und Größenverteilung der Partikel hängen vor allem von der Korngröße des in der Arbeitsfläche des Schleifwerkzeugs gebundenen Schleifkorns ab. Es ist daher zweckmäßig, die Verteilung der Partikelgrößen des zerspanten Halbleitermaterials zu ermitteln und das Reinigungsmittel mit Schallwellen solcher Frequenzen zu beaufschlagen, die eine besonders wirksame Entfernung der Partikel erwarten läßt. Vorzugsweise werden 2 bis 10, besonders bevorzugt 2 bis 3, verschiedene Frequenzen eingesetzt. Eine Weiterbildung des Verfahrens sieht zusätzlich eine Gewichtung der verwendeten Frequenzen vor, indem das Reinigungsmittel mit Schallwellen unterschiedlicher Frequenz und unterschiedlicher Intensität beaufschlagt wird. Auf diese Weise wird die Wirkung des Reinigungsmittels weiter optimiert.

Die Reinigungsmittel-Strahlen werden durch den Ausstoß des Reinigungsmittels aus Düsen erzeugt. Die Beschallung der Reinigungsmittel-strahlen kann von einer externen Schallquelle aus erfolgen, beispielsweise von einem außerhalb der Düsen angeordnetem Schallerzeuger. Es ist

jedoch wieder bevorzugt, das Reinigungsmittel bereits in den Düsen mit Schallwellen zu beaufschlagen.

Zur Durchführung der Erfindung sind Ultraschallwellen mit einer Frequenz von 100 kHz bis 10 MHz, insbesondere von 0,5 bis 3 MHz, bevorzugt. Die Intensität der Schallwellen beträgt vorzugsweise 10 bis 500 W, wobei sich diese Zahlenangabe auf die elektrische Leistungsabgabe zur Erzeugung der Schallwellen bezieht.

Grundsätzlich eignen sich alle bereits bekannten Reinigungsmittel, die während der schleifenden Behandlung von Halbleitermaterial mit der Arbeitsfläche des Schleifwerkzeugs in Kontakt gebracht werden. Bevorzugt sind Wasser und flüssige Kühlschmiermittel oder beliebige Mischungen davon.

Gegenstand der Erfindung ist auch eine Vorrichtung zur Bearbeitung von Halbleitermaterial mit einem Schleifwerkzeug und unter Zuführung eines Reinigungsmittels zur Arbeitsfläche des Schleifwerkzeugs, mit Mitteln zum Beaufschlagen des Reinigungsmittels mit Schallwellen, die gekennzeichnet ist durch zwei bis zehn Düsen, in denen Schallwellen unterschiedlicher Frequenz erzeugt werden die gegen die Arbeitsfläche des Schleifwerkzeugs gerichtet sind, mit je einem in der Düse integrierten Element, das Schallwellen einer bestimmten Frequenz und Intensität erzeugt, und mit je einem das Element zum Schwingen anregenden Oszillator.

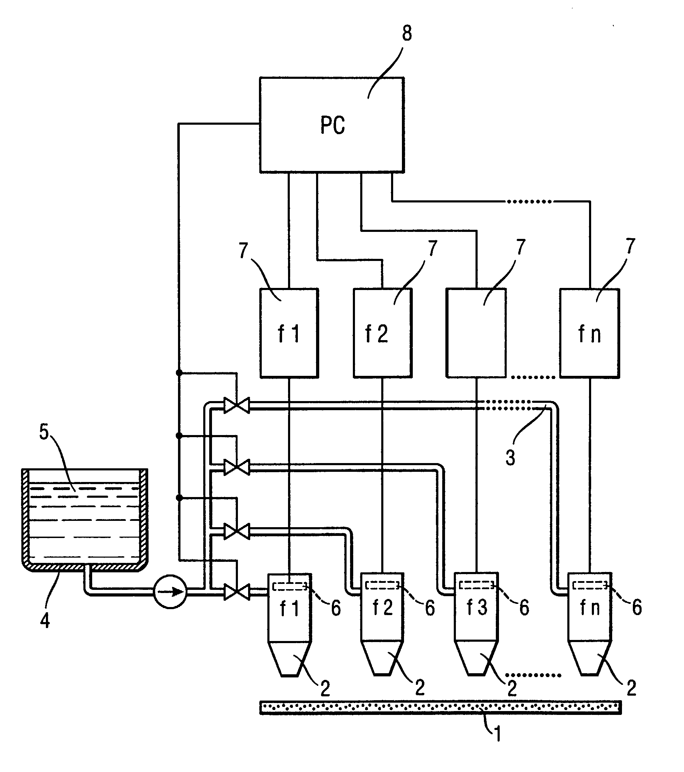

Die Vorrichtung ist in der Figur schematisch dargestellt. die Figur zeigt nur Merkmale, die zum besseren Verständnis der Erfindung notwendig sind.

Gegen die Arbeitsfläche 1 des Schleifwerkzeugs, beispielsweise die Schneidkante des Sägeblatts einer Innenlochsäge, sind mehrere Düsen 2 gerichtet. Die Düsen sind über Zuführungsleitungen 3 mit einem Vorratsbehälter 4 verbunden, der das Reinigungsmittel 5 enthält. Jede Düse kann auch an einen eigenen Vorratsbehälter angeschlossen sein, beispielsweise falls verschiedene Reinigungsmittel gewünscht sind. In jeder Düse befindet sich ein schallerzeugendes Element 6, das beispielsweise aus Tantal oder piezo-keramischem Material gefertigt ist. Diese Elemente (transducer) werden von zugehörigen Wechselspannungsquellen 7, den sogenannten Oszillatoren, zu Schwingungen bestimmter Frequenz und Intensität angeregt. Das flüssige Reinigungsmittel wird während der Behandlung des Halbleitermaterials unter Druck aus den Düsen heraus auf die Arbeitsfläche des in der Regel rotierenden Schleifwerkzeugs gesprüht. Beim Durchgang durch die Düsen wird Schallenergie auf das Reinigungsmittel übertragen. Die Frequenz der Schallwellen ist von dem in der Düse integrierten Element 6 abhängig. Ihre Intensität richtet sich nach der Leistungsabgabe des zugehörigen Oszillators. Vorzugsweise werden 2 bis 10 Düsen bereitgestellt, in denen Schallwellen unterschiedlicher Frequenz erzeugt werden können.

Eine Weiterbildung der Vorrichtung hat als zusätzliches Merkmal eine Steuerungs-Einrichtung 8, beispielsweise eine Mikroprozessor-Steuerung, mit der die Funktion jeder der zur Verfügung stehenden Düsen 2 nach einem vorgegebenem Programm gesteuert wird. Als steuerbare Parameter kommen die Abgabe von Reinigungsmittel, die Schallerzeugung in einer Düse und die Intensität des in der Düse erzeugten Schalls in Frage.

### Beispiel

Mit einer herkömmlichen Innenlochsäge wurden Silicium-Halbleiterscheiben mit einem Scheibendurchmesser von 200 mm von einem Einkristallstab abgetrennt. Während des Trennvorgangs wurde Wasser als Reinigungsmittel aus einer Düse auf die Schneidkante des Sägeblatts der Innenlochsäge gesprüht. Insgesamt wurden drei Testreihen gefahren, davon eine als Vergleichstest. Im Vergleichstest erfolgte keine Beaufschlagung des Reinigungsmittels mit Schallwellen. Während der Testreihe I) wurde das Reinigungsmittel in der Düse mit Ultraschall einer Frequenz von 1 MHz beaufschlagt, und während der Testreihe II) nach einem Düsenwechsel unter sonst unveränderten Bedingungen mit Ultraschall einer Frequenz von 3 MHz. Die Ergebnisse der Testreihen sind nachfolgend tabellarisch aufgelistet:

| | Vergleich | Testreihe I) | Testreihe II) |
|---|---|---|---|
| Vorschub^{*)} | 100 | 150 | 150 |
| Ausbringung^{*)} | 100 | 147 | 147 |
| warp^{***)} | 100 | 72,5 | 59,4 |
| TTV^{*)}**⁾^{***)} | 100 | 89,0 | 72,1 |

| | | | |
|---|---|---|---|
| ^{*)} Zahlenangaben in relativen Einheiten | | | |
| ^{**)} Zahlenwert: 3 sigma (99,87 %) aller Scheiben gleich oder besser | | | |
| ^{***)} TTV = total thickness variation | | | |

## Patentansprüche

1. Verfahren zur Bearbeitung von Halbleitermaterial mit einem Schleifwerkzeug und unter Zufuhrung eines Reinigungsmittels zur Arbeitsfläche des Schleifwerkzeugs, wobei das Reinigungsmittel mit Schallwellen einer bestimmten Frequenz und einer bestimmten Intensität beaufschlagt wird, dadurch gekennzeichnet, daß das Reinigungsmittel in mindestens zwei Reinigungsmittel-Strahlen gegen die Arbeitsfläche des Schleifwerkzeugs gelenkt wird, die sich darin unterscheiden, daß sie mit Schallwellen unterschiedlicher Frequenz beaufschlagt sind, um die beim Schleifen entstehenden Partikel unterschiedlicher Korngröße mit an deren Korngröße angepaßten Frequenzen zu entfernen.

2. Verfahren nach Anspruch 1, dadurch gekennzeichnet, daß sich mindestens zwei Reinigungsmittel-Strahlen darin unterscheiden, daß sie mit Schallwellen unterschiedlicher Intensität beaufschlagt sind.

3. Verfahren nach Anspruch 1 oder Anspruch 2, dadurch gekennzeichnet, daß das Reinigungsmittel mit Schallwellen einer Frequenz von 0,1 bis 10 MHz und einer Intensität von 10 bis 500 W beaufschlagt wird.

4. Verfahren nach einem der Ansprüche 1 bis 3, dadurch gekennzeichnet, daß die Wirkung des Reinigungsmittels über die Frequenz oder über die Frequenz und die Intensität der Schallwellen gesteuert wird.

5. Vorrichtung zur Bearbeitung von Halbleitermaterial mit einem Schleifwerkzeug und unter Zuführung eines Reinigungsmittels zur Arbeitsfläche des Schleifwerkzeugs, mit Mitteln zum Beaufschlagen des Reinigungsmittels mit Schallwellen, gekennzeichnet durch 2 bis 10 Düsen, die gegen die Arbeitsfläche des Schleifwerkzeugs gerichtet sind, die sich darin unterscheiden, daß sie mit Schallwellen unterschiedlicher Frequenz beaufschlagt sind, mit je einem in der Düse integrierten Element, das die Schallwellen mit einer bestimmten Frequenz und Intensität erzeugt, und mit je einem das Element zum Schwingen anregenden Oszillator, um die beim Schleifen entstehenden Partikel unterschiedlicher Korngröße mit an deren Korngröße angepaßten Frequenzen zu entfernen.

6. Vorrichtung nach Anspruch 5, gekennzeichnet durch eine Steuerungseinrichtung, mit der die Erzeugung der Schallwellen in der Düse, die Intensität der erzeugten Schallwellen und die Abgabe von Reinigungsmittel aus der Düse gesteuert wird.

## Claims

1. Method for machining semiconductor material with a grinding tool while feeding a cleaning agent to the working surface of the grinding tool, the cleaning agent being exposed to sound waves having a specific frequency and a specific intensity, characterized in that the cleaning agent is guided in at least two cleaning agent jets against the working surface of the grinding tool, which jets differ in that they are exposed to sound waves of different frequency, in order to remove the particles which are formed during grinding and are of differing particle size with frequencies which are matched to their particle size.

2. Method according to Claim 1, characterized in that at least two cleaning agent jets differ in that they are exposed to sound waves of different intensity.

3. Method according to Claim 1 or Claim 2, characterized in that the cleaning agent is exposed to sound waves with a frequency of 0.1 to 10 MHz and an intensity of 10 to 500 W.

4. Method according to any of Claims 1 to 3, characterized in that the action of the cleaning agent is controlled by means of the frequency or by means of the frequency and the intensity of the sound waves.

5. Device for machining semiconductor material with a grinding tool while feeding a cleaning agent to the working surface of the grinding tool, having means for exposing the cleaning agent to sound waves, characterized by 2 to 10 nozzles which are directed against the working surface of the grinding tool and differ in that they are exposed to sound waves of different frequency, and each having a component which is built into the nozzle and which generates the sound saves having a specific frequency and intensity, and each having an oscillator which excites the component to vibrate, in order to remove the particles which are formed during grinding and are of differing particle size with frequencies which are matched to their particle size.

6. Device according to Claim 5, characterized by a control device with which the generation of the sound waves in the nozzle, the intensity of the sound waves generated and the output of cleaning agent from the nozzle is controlled.

## Revendications

1. Méthode pour le traitement de matériaux semi-conducteurs avec un outil de polissage et avec l'adjonction d'un produit de nettoyage sur la surface de travail de l'outil de polissage, le produit de nettoyage étant soumis à des ondes sonores d'une fréquence définie et d'une intensité définie, caractérisée en ce que le produit de nettoyage est dirigé contre la surface de travail de l'outil de polissage par deux jets au moins de produit de nettoyage, qui se distinguent en ce qu'ils sont soumis à des ondes sonores de fréquence différente pour éliminer les particules de différentes tailles de grains apparaissant lors du polissage au moyen des fréquences adaptées à la taille des grains.

2. Méthode selon la revendication 1, caractérisée en ce que deux jets au moins de produit de nettoyage se distinguent en ce qu'ils sont soumis à des ondes sonores d'intensité différente.

3. Méthode selon la revendication 1 ou la revendication 2, caractérisée en ce que le produit de nettoyage est soumis à des ondes sonores d'une fréquence de 0,1 à 10 MHz et d'une intensité de 10 à 500 W.

4. Méthode selon l'une quelconque des revendications 1 à 3, caractérisée en ce que l'efficacité du produit de nettoyage est pilotée au moyen de la fréquence ou au moyen de la fréquence et de l'intensité des ondes sonores.

5. Appareil pour le traitement de matériaux semi-conducteurs avec un outil de polissage et avec l'adjonction d'un produit de nettoyage sur la surface de travail de l'outil de polissage, avec des moyens pour soumettre le produit de nettoyage à des ondes sonores caractérisés par 2 à 10 buses dirigées contre la surface de travail de l'outil de polissage, qui se distinguent en ce qu'elles sont soumises à des ondes sonores de fréquence différente, chacune avec un élément intégré dans la buse, qui génère les ondes sonores avec une fréquence et une intensité définies, et chacune avec un oscillateur excitant l'élément pour le faire vibrer, pour éliminer les particules de différentes tailles de grains apparaissant lors du polissage au moyen des fréquences adaptées à la taille des grains.

6. Appareil selon la revendication 5, caractérisé par une installation de pilotage qui permet de piloter la génération des ondes sonores dans la buse, l'intensité des ondes sonores générées et le débit de produit de nettoyage de la buse.
